# EUROPÄISCHE PATENTANMELDUNG

(11) **EP 1 638 028 A2**
(43) Veröffentlichungstag der Anmeldung: **22.03.2006**
(21) Anmeldenummer: 05107447.4
(22) Anmeldetag: 12.08.2005
(51) Int. Cl.: G06F 17/50

(54) **Rechnergestützte Erzeugung und Änderungsmanagement für Bedienoberflächen**

(30) Priorität: 24.08.2004 DE 102004040976
(71) Anmelder: SIEMENS AKTIENGESELLSCHAFT, 80333 München (DE)
(72) Erfinder: Walter, Dieter, 91093, Hessdorf (DE)

(57) **Zusammenfassung**

Die Erfindung betrifft ein System und ein Verfahren zur Generierung und/oder Modifikation von Bedienoberflächen, insbesondere von B&B-Systemen in der Automatisierungstechnik. Es wird ein System und ein Verfahren angegeben, mit dessen Hilfe eine automatische Generierung von HMI-Bildern sowie eine automatische Modifizierung bereits erstellter HMI-Bilder auf Basis von CAD-Plänen ermöglicht wird. Die für die Generierung des HMI notwendigen CAD-Daten werden gegebenenfalls vom Projekteur zusätzlich qualifiziert (z.B. Betriebsmittelzuordnung, Gruppierungen). Die vorliegenden Quelldaten werden automatisch extrahiert und in ein XML-Format umgesetzt. Betriebsmittelgruppen werden als HMI-Areas dargestellt. Jeder HMI-Area kann ein Hintergrundbild (aus CAD-Plan extrahiert) zugeordnet werden. Die Anzeigeelemente für die einzelnen Betriebsmittel werden positionsgenau vor dem Hintergrundbild eingefügt. Ein Template für die Steuerung des Generiervorgangs wird ebenfalls automatisch erzeugt. Der HMI-Designer passt dieses Template der Generiervorschrift an. Anhand der qualifizierten CAD-Daten und der Generiervorschrift wird automatisch das HMI für das B&B System neu erzeugt bzw. aktualisiert.

## Beschreibung

Die Erfindung betrifft ein System und ein Verfahren zur Generierung und/oder Modifikation von Bedienoberflächen, insbesondere von B&B-Systemen in der Automatisierungstechnik.

Bei der Planung und Realisierung von Anlagen, insbesondere im Industrieumfeld, nehmen CAD-Pläne, in welchen beispielsweise das Anlagen-Layout, Elektropläne oder R&I-Diagramme dargestellt werden, die zentrale Eingabe- und Kommunikationssicht ein. Die Bedeutung der CAD-Pläne spiegelt sich auch in dem Wunsch der Anwender wieder, die im Plan enthaltenen Komponenten, Strukturen und Geometrie-Informationen für die Bilderstellung im HMI-(Human Machine Interface) verwenden bzw. wieder verwenden zu können. Hierbei werden im HMI bzw. an der Oberfläche eines B&B-Systems die einzelnen Komponenten einer Anlage nicht direkt der Wirklichkeit entsprechend angezeigt, sondern sie werden vielmehr idealisiert dargestellt. Hierbei erfahren die Bildelemente der CAD-Pläne eine Dynamisierung.

Eine Umwandlung von CAD-Plänen direkt in HMI-Bilder wird heute bereits von einigen Werkzeugen bzw. Applikationen unterstützt. Hierbei müssen die für das HMI erzeugten Bilder jedoch in der Regel nachträglich noch qualifiziert werden, dass heißt, den erstellten Bildern müssen nachträglich die notwendigen Betriebsmittel zugewiesen werden und eine Positionierung der erstellten Bilder muss nachträglich durch den Projekteur durchgeführt werden. Eine automatische Qualifizierung, das heißt die Zuordnung der CAD-Zeichnungselemente zu den Betriebsmitteln, erfolgt nicht automatisch. Eine Generierung von HMI-Bildern erfolgt heutzutage zum Teil auch über so genannte Export-/Import-Listen. Dieses Vorgehen ist in der Regel jedoch Zielsystem abhängig.

Im Rahmen der Realisierung und Planung einer Anlage werden bereits erstellte CAD-Pläne häufig geändert. Dies erfolgt in der Regel auch zu einem Zeitpunkt, zu dem die HMI-Oberflächen bereits projektiert werden. Bei der Verwendung von CAD-Plänen für die HMI-Bilderstellung können in diesem Fall nachträglich getätigte Änderungen nicht in die HMI-Projektierung übernommen werden, ohne dass durchgeführte Anpassungen dabei verloren gehen. Werden CAD-Pläne nachträglich geändert, zum Beispiel durch das Verschieben eines Anlagenteils, das Einfügen von Betriebsmitteln oder der gleichen, so müssen diese Änderungen eingespielt werden und dies muss unter Beibehaltung der vorgenommenen Bildprojektierung (zum Beispiel Zuordnung eines Bildbausteins zu einem Förderelement) und bereits manuell durchgeführter Anpassungen am Layout des HMI erfolgen. Die bereits durchgeführten Anpassungen durch den HMI-Projekteur gehen bei der nachträglichen Umwandlung von geänderten CAD-Plänen zu HMI-Bildern verloren. Ein HMI-Projekteur muss aus diesem Grund sämtliche manuell getätigten Änderungen ein weiteres Mal durchführen, wenn eine Änderung im CAD-Plan eine Anpassung bzw. Modifikation des HMI-Systems zur Folge hat.

In heutigen Systemen erfolgt die Qualifizierung der Bilder, beispielsweise die Zuweisung von Betriebsmitteln bzw. die Positionierung von Betriebsmitteln nachträglich, nach Erstellung der CAD-Pläne. Diese qualifizierten Daten werden in einer Datenbank abgelegt. Es entsteht somit eine Datenablage, in der die notwendigen Betriebsmittel bereits spezifiziert sind. Aus diesen Datenbanken heraus ist es bisher jedoch nicht möglich, automatisch eine HMI-Oberfläche, welche auf dem entsprechenden zugrunde liegenden CAD-Plan basiert, zu erstellen.

Die der Erfindung zugrunde liegende Aufgabe besteht daher darin, ein System und ein Verfahren anzugeben, mit dessen Hilfe eine automatische Generierung von HMI-Bildern sowie eine automatische Modifizierung bereits erstellter HMI-Bilder auf Basis von CAD-Plänen ermöglicht wird.

Die Aufgabe wird gelöst durch ein System zur Generierung und/oder Modifikation von Bedienoberflächen, insbesondere von B&B Systemen in der Automatisierungstechnik, mit ersten Mitteln zur Extraktion von Daten aus CAD-Plänen, wobei die Daten insbesondere eine Zuordnung von CAD-Zeichnungselementen zu Betriebsmitteln darstellende Qualifizierungsdaten sind, zweiten Mitteln zur Ablage der extrahierten Daten in einer Standardsprache, insbesondere in XML und einer Template-Datei zur Steuerung eines Generiervorgangs mindestens einer Bedienoberfläche, insbesondere zur Zuordnung von Betriebsmitteln zu für die Darstellung der Betriebsmittel auf der Bedienoberfläche verwendbaren Bildelementen, wobei eine Generierung und/oder Modifikation einer Bedienoberfläche anhand der Daten, insbesondere der Qualifizierungsdaten und einer in der Template-Datei enthaltenen, insbesondere in XML vorliegenden Generiervorschrift, vorgesehen ist.

Der Erfindung liegt die Erkenntnis zugrunde, dass in der Regel CAD-Systeme in der Lage sind, erstellte Zeichnungen in einem einheitlichen Format, beispielsweise DXF,ASC abzulegen. Das erfindungsgemäße System ist in der Lage, aus diesen im einheitlichen Format abgelegten Zeichnungen die für die Erstellung eines HMI-Bilds benötigten Daten zu extrahieren. Diese extrahierten Daten werden anschließend in einem Standardformat, beispielsweise im XML-Format abgelegt. Das XML-Format hat den Vorteil, dass es mit einer Vielzahl von auf dem Markt befindlichen Werkzeugen in standardisierter Weise bearbeitet und weiterverarbeitet werden kann.

Die Zuordnung der CAD-Zeichnungselemente zu Betriebsmitteln, die so genannte Qualifizierung der CAD-Daten, wird von unter-schiedlichen Engineering-Systemen unterschiedlich gehandhabt. Die qualifizierten Daten werden zumeist jedoch in Datenbanken mit proprietärem Aufbau abgelegt. Die in der Regel vorhandenen Qualifizierungsdaten, die notwendig sind, um die HMI-Bilder zu erzeugen, werden mittels des erfindungsgemäßen Systems aus der jeweiligen Datenablage extrahiert und ebenfalls in einem Standardformat, beispielsweise in XML abgelegt.

Die notwendige Zuordnung der Betriebsmittel zu den für ihre Darstellung im HMI verwendeten Bildelementen und deren Eigenschaften wird über eine so genannte Template-Datei, welche ebenfalls im XML-Format vorliegt, durchgeführt. Das erfindungsgemäße System erzeugt diese Datei anhand der vorliegenden qualifizierten CAD-Daten initial. Die Template-Datei steuert den Generier- bzw. Modifiziervorgang, so dass eine Bedienoberfläche eines HMI entsteht, in welchem die Zuordnung von Betriebsmitteln zu den für die Darstellung der Betriebsmittel verwendeten Bildelementen automatisch erfolgt. Hierbei liegen für die Darstellung von Betriebsmitteltypen im HMI Typen-Informationen, zum Beispiel über verschiedene Anlagenteile, wie Förderbänder oder Gehänge vor. Das eigentliche Abbild der CAD-Zeichnung im HMI-Bild erfolgt für die jeweiligen Instanzen der einzelnen Betriebsmitteltypen über eine Element-ID, die bereits in der Datenablage, in welcher die qualifizierten Daten gehalten werden, vorliegt. Eine Modifizierung bzw. eine Erstellung eines HMI-Bildes erfolgt dann anhand der extrahierten Qualifizierungsdaten und der in der Template-Datei vorliegenden Generiervorschrift für das HMI.

Neben der Struktur der Betriebsmittel und deren Darstellung im HMI werden auch Daten bezüglich ihrer Anbindung an den Prozess (B&B von Prozessvariablen) benötigt. Die Namen der verwendeten Prozessvariablen werden ebenfalls aus den in der Datenablage vorhandenen, qualifizierten Daten abgeleitet. Dies setzt eine entsprechende Programmierung der verwendeten Automatisierungssoftware (zum Beispiel die Verwendung von Strukturvariablen) voraus.

Auch für das Erkennen eines Fehlerzustandes für ein einzelnes Betriebsmittel ist die Prozessanwendung notwendig und in den qualifizierten Daten enthalten. Im Rahmen des erfindungsgemäßen Systems können mehrere Betriebsmittel zu einer Betriebsmittelgruppe zusammengefasst werden. Für die Fehleranzeige einer derartigen Betriebsmittelgruppe werden die Bedingungen der zugehörigen Betriebsmittelkomponenten ver-odert. Ein Fehlerzustand kann zum Beispiel durch Blinken der entsprechenden Bildelemente angezeigt werden.

Derartige Betriebsmittelgruppen werden als so genannte HMI-Areas dargestellt. Jeder HMI-Area kann im HMI-System ein Hintergrundbild zugeordnet werden. Das Hintergrundbild wird auf Basis der im CAD-Plan vorliegenden Geometriedaten erstellt. Hierzu werden die Daten ebenfalls aus dem CAD-Plan extrahiert. Die Anzeigenelemente auf der B&B-Oberfläche für die einzelnen Betriebsmittel können somit positionsgenau vor dem Hintergrundbild eingefügt werden. Eine Verschachtelung von HMI-Areas und damit Darstellungen mit unterschiedlicher Detailtiefe ist möglich. Im erfindungsgemäßen System können die HMI-Areas sowohl in Draufsicht als auch als senkrechte HMI-Areas definiert werden. Die einzelnen Betriebsmittel werden einer HMI-Area zugewiesen. Einer HMI-Area werden die ihr zugehörigen Betriebsmitteltypen aus der Datenbank, insbesondere Typ ID, Name und Beschreibung zugewiesen. Des Weiteren wird der HMI-Area die jeweilige Instanzen-Info der einzelnen Betriebsmittel zugewiesen.

Die Template-Datei, welche eine Zuordnung der Betriebsmittel zu den für ihre Darstellung im HMI verwendeten Bildelementen und deren Eigenschaften durchführt, kann von einem HMI-Designer angepasst werden, um die Darstellung der jeweiligen Betriebsmittel im HMI zu beeinflussen. So ist beispielsweise über das Template bzw. die Template-Datei ein Offset eingebbar. Wenn beispielsweise zwei Betriebsmittel in der Vertikalen in der Realität übereinander angeordnet sind, so kann der HMI-Designer einem dieser Betriebsmittel ein Offset zuweisen, dass die Betriebsmittel im HMI-Abbild versetzt dargestellt werden. Ebenso können ganze HMI-Areas mit einem Offset versehen werden, so dass sie im HMI an einer anderen Stelle dargestellt werden können als sie in Wirklichkeit positioniert sind.

Die Erzeugung eines HMI-Bildes wird von dem erfindungsgemäßen System in einer Datei, beispielsweise einer XML-Datei protokolliert; es entsteht ein so genanntes Generierprotokoll. Dies ermöglicht ein komfortables Round-Trip-Engineering. Unter einem Round-Trip-Engineering wird das neuerliche Erzeugen eines HMI-Bildes nach Änderung der qualifizierten CAD-Daten und/oder der Template-Datei verstanden. Dabei bleiben die vom HMI-Designer bereits durchgeführten Anpassungen im HMI auf Wunsch erhalten. Die Änderung von Objekten in CAD-Zeichnungen kann erkannt werden, da die Objekte in den CAD-Zeichnungen eine eindeutige ID aufweisen. Hierdurch ist es möglich zu erkennen, ob ein Objekt gelöscht, verändert oder hinzugefügt wurde. Mittels des erfindungsgemäßen Systems können somit nachträglich geänderte CAD-Pläne eingespielt werden, ohne die bisherigen allgemeinen Bildprojektierungsinformationen zu verlieren (zum Beispiel die Zuordnung eines Bildbausteins zu einem Förderelement).

Die vorliegenden CAD-Grafikinformationen, angereichert durch die qualifizierten Daten, können nahezu beliebig für die Erstellung des B&B-HMI verwendet werden. Die mittels des Systems gewonnenen Daten können über entsprechende Transformationen zusammengeführt bzw. kombiniert werden. Die Transformationen werden über XML-Datenstrukturen gesteuert und mit Standardwerkzeugen durchgeführt (XSLT). Da die ermittelten Daten in einem leicht weiterverarbeitbaren Format vorliegen (XML), ergeben sich vielfältige Möglichkeiten für Ihre Anwendung.

Im Folgenden wird die Erfindung anhand der in den Figuren dargestellten Ausführungsbeispiele näher beschrieben und erläutert. Es zeigen:
- Figur 1: eine schematische Übersicht über das System zur Generierung und Modifikation von Bedienoberflächen,
- Figur 2: eine schematische Darstellung eines Folgezyklus bei Änderung der CAD-Daten und
- Figur 3: eine schematische Darstellung einer Modifikation des HMI-Bilds mit Abgleich bereits durchgeführter Anpassungen.

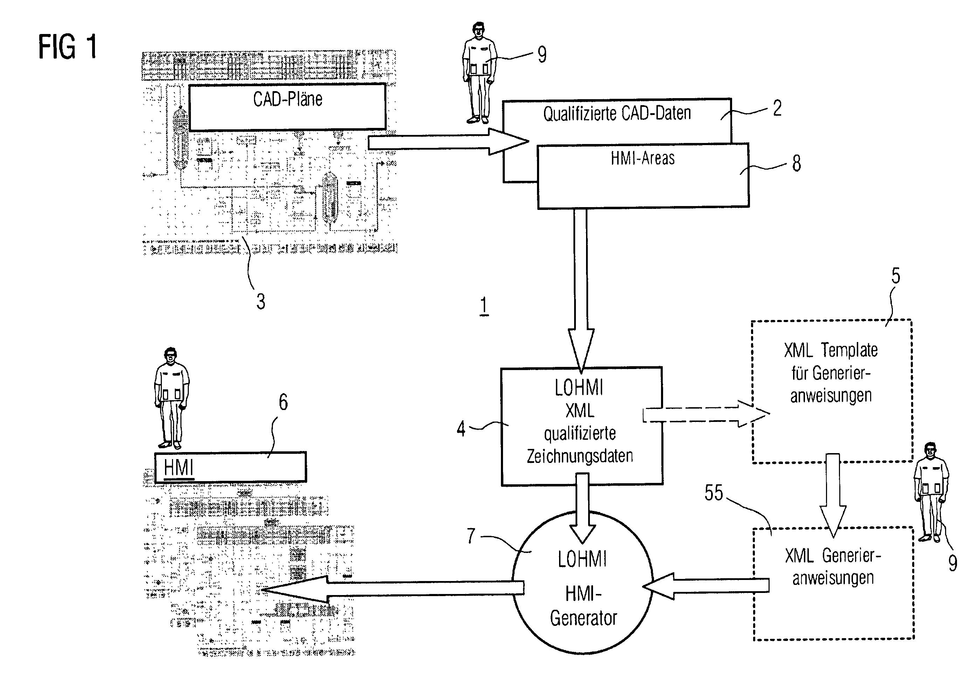

Figur 1 zeigt eine schematische Übersicht über System 1 zur Generierung und/oder Modifikation von Bedienoberflächen 6. Hierbei werden in CAD-Plänen 3 enthaltene Informationen und qualifizierte, das heißt den entsprechenden Betriebsmitteln zugeordnete CAD-Zeichnungselemente in Form von CAD-Daten extrahiert. Die Extraktion der Qualifizierungsdaten erfolgt durch die ersten Mittel 2. Die qualifizierten Daten werden durch die zweiten Mittel 4 in einer Standardsprache, insbesondere in XML abgelegt. Das System 1 generiert eine Template-Datei 5, in der die Generieranweisungen für die Bedienoberfläche 6 abgelegt werden. Die Generieranweisungen 55 für die Bedienoberfläche 6 liegen insbesondere in Form einer XML-Generiervorschrift vor. Durch den HMI-Generator 7 wird die Bedienoberfläche 6 also das HMI (Human Machine Interface) auf Basis der qualifizierten Daten 4 und der Generieranweisung 55 generiert bzw. modifiziert.

Durch einen Projekteur 9 kann das Template mit der Generieranweisung 55 individuell weiter angepasst werde. Ein Projekteur 9 kann in dem System ebenfalls händisch Änderungen einfügen, die die Generieranweisungen 55 für die Bedienoberfläche 6 betreffen. Hierbei kann ein Projekteur 9 insbesondere gestalterische Änderungen für die Bedienoberfläche 6 in die Generieranweisungen einfügen, beispielsweise unterschiedliche Farben oder Hintergrundbilder sowie einen Offset für die Darstellung verschiedener Betriebsmittel. Ein Einfügen eines Offsets führt beispielsweise dazu, dass in Realität übereinander liegende Betriebsmittel auf dem HMI 6 nebeneinander dargestellt werden können.

Aus den CAD-Plänen 3 können weiterhin durch eine Qualifizierung Gruppen von Betriebsmitteln zusammengefasst werden zu so genannten HMI-Areas 8. Die HMI-Areas werden entsprechend gemeinsam auf der Bedienoberfläche 6 dargestellt. Beispielsweise kann für die zu einer HMI-Area 8 gehörenden Betriebsmittel ein dieser HMI-Area zugehöriges Hintergrundbild in der Bedienoberfläche 6 angelegt werden. Des Weiteren können beispielsweise Fehleranzeigen für eine Gruppe von Betriebsmitteln gemeinsam angezeigt werden.

In dem vorliegenden System wird durch die Verwendung der qualifizierten Zeichnungsdaten 4 aus den CAD-Plänen 3 in Kombination mit den in der Template-Datei 5 vorliegenden Generieranweisungen für das HMI automatisch eine Bedienoberfläche 6 erzeugt. Ein Projekteur 9 kann jedoch eine individuelle Anpassung der Qualifizierungsdaten sowie der Generiervorschriften durchführen.

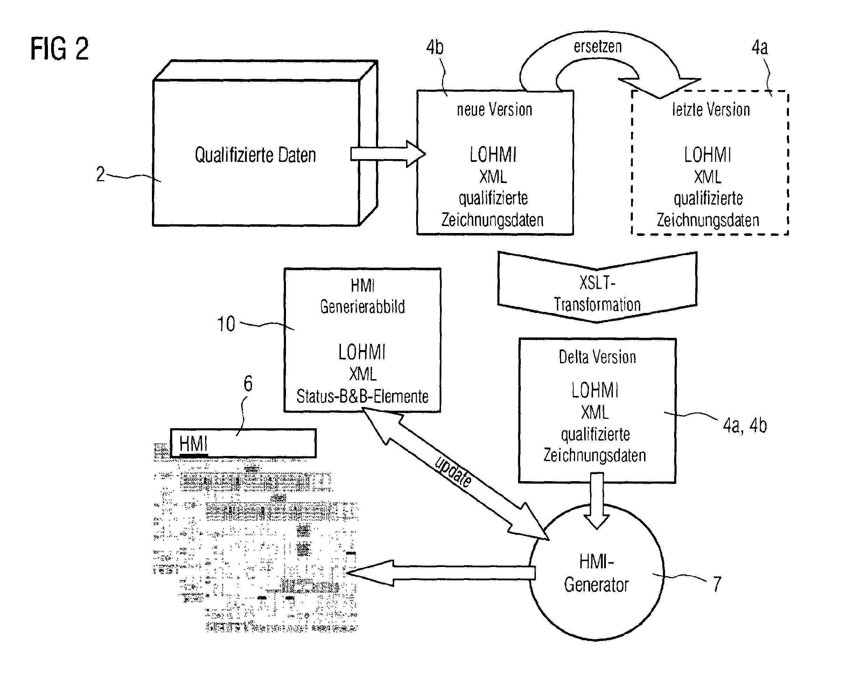

Figur 2 stellt die Modifikation bzw. das Update von Bedienoberflächen 6 mit Hilfe des vorliegenden Systems 1 dar. Die qualifizierten Daten 2, welche beispielsweise aus einem erneut geänderten CAD-Plan 3 extrahiert werden, werden in einer neuen Version durch die zweiten Mittel zur Ablage der extrahierten Daten abgelegt. Die neue Version der qualifizierten Daten 4b soll die alte Version der qualifizierten Daten 4a ersetzen. Hierbei wird ein Abgleich der beiden Versionen 4a und 4b durchgeführt. Es werden nur solche qualifizierten Daten ersetzt, bei denen sich etwas geändert hat. Die abgeglichene Version 4a,b stellt die so genannte Delta-Version der qualifizierten Zeichnungsdaten dar. Im erfindungsgemäßen System 1 wird bei der Erstellung der Bedienoberfläche 6 jeweils ein Generierprotokoll, welches die einzelnen Schritte, die bei der Generierung der Bedienoberfläche 6 durchgeführt wurden, gespeichert. In dem HMI-Generierprotokoll bzw. Abbild 10, welches ebenfalls insbesondere im XML-Format vorliegt, werden die Daten zu allen automatisch generierten Bildelementen gespeichert. Werden in der Delta-Version 4 a,b der qualifizierten Daten neue oder gelöschte Betriebmittel erkannt, so werden diese Änderungen direkt in das HMI, somit ohne Rückfrage, übernommen.

Werden in der Delta- Version der qualifizierten Daten 4a,b Änderungen der Eigenschaften, z. B. der Position erkannt, so überprüft das System 1 anhand des Vergleichs von Generierprotokoll 55 mit existierendem HMI, ob der Projekteur bereits manuell Änderungen durchgeführt hat. Ist dies der Fall, so wird der Anwender bzw, der Projekteur 9 befragt, ob er die entsprechende Änderung in der Bedienoberfläche 6 beibehalten möchte oder ob die geänderte Eigenschaft für ihn akzeptabel ist und die Aktion entsprechend der Generiervorschrift 55 durchgeführt werden kann. Einmal durchgeführte Änderungen bleiben somit bei einer neuen Version erhalten. Die Änderungen gehen nicht, wie bisher, verloren. Betriebsmittel können beispielsweise mit einem Offset für ihre Darstellung versehen werden, Hintergrundbilder für eine HMI-Area 8 werden entsprechend den einmal durch den Projekteur 9 zugewiesenen Parametern dargestellt.

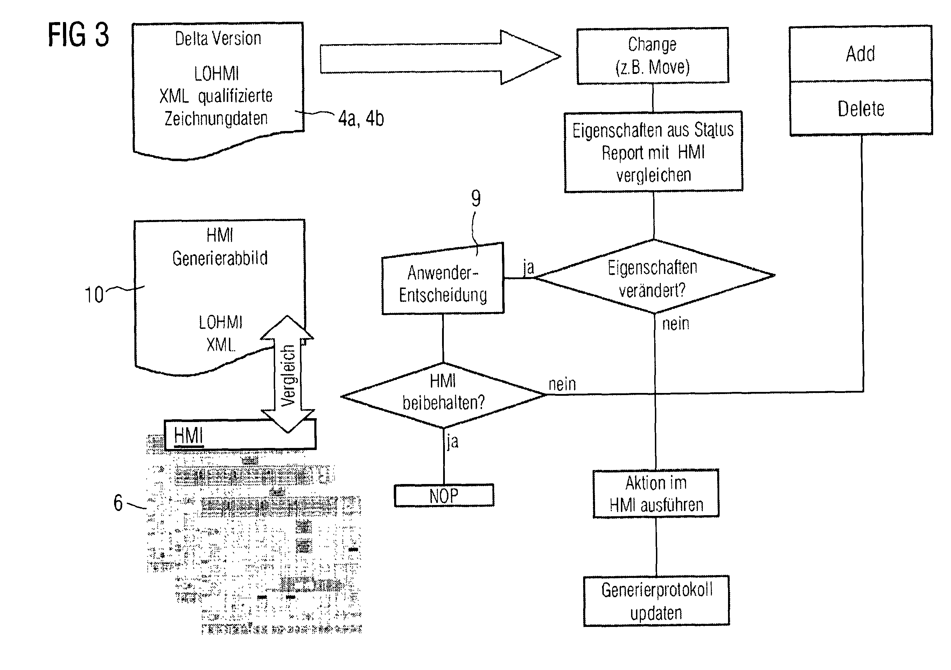

Figur 3 zeigt die einzelnen Schritte, die durchlaufen werden, wenn die neu erstellte Delta-Version 4a,b der qualifizierten Zeichnungsdaten und das Generierprotokoll 55 bzw. das HMI-Generierabbild 10 mit dem existierenden HMI verglichen wird. Hierbei werden für die einzelnen darzustellenden Betriebsmittel die Positionen aus dem Generierprotokoll 55 mit dem HMI verglichen. Hat eine Position sich nicht verändert, so kann die in der Generiervorschrift vorliegende Aktion ausgeführt werden und das Betriebsmittel wird entsprechend dargestellt. Somit ist durch das System 1 sichergestellt, dass durch Änderungen in den CAD-Plänen 3 verursachte Änderungen auf der Bedienoberfläche 6 durch den Projekteur 9 zur Kenntnis genommen werden und von ihm durchgeführte Änderungen im Layout durch die Aktualisierung bzw. Modifikation nicht verloren gehen.

Zusammenfassend betrifft die Erfindung ein System und ein Verfahren zur Generierung und/oder Modifikation von Bedienoberflächen, insbesondere von B&B-Systemen in der Automatisierungstechnik. Es wird ein System und ein Verfahren angegeben, mit dessen Hilfe eine automatische Generierung von HMI-Bildern sowie eine automatische Modifizierung bereits erstellter HMI-Bilder auf Basis von CAD-Plänen ermöglicht wird. Die für die Generierung des HMI notwendigen CAD-Daten werden gegebenenfalls vom Projekteur zusätzlich qualifiziert (z.B. Betriebsmittelzuordnung, Gruppierungen). Die vorliegenden Quelldaten werden automatisch extrahiert und in ein XML-Format umgesetzt. Betriebsmittelgruppen werden als HMI-Areas dargestellt. Jeder HMI-Area kann ein Hintergrundbild (aus CAD-Plan extrahiert) zugeordnet werden. Die Anzeigeelemente für die einzelnen Betriebsmittel werden positionsgenau vor dem Hintergrundbild eingefügt. Ein Template für die Steuerung des Generiervorgangs wird ebenfalls automatisch erzeugt. Der HMI-Designer passt dieses Template der Generiervorschrift an. Anhand der qualifizierten CAD-Daten und der Generiervorschrift wird automatisch das HMI für das B&B System neu erzeugt bzw. aktualisiert.

## Patentansprüche

1. System zur Generierung und/oder Modifikation von Bedienoberflächen, insbesondere von B&B Systemen in der Automatisierungstechnik, mit
• ersten Mitteln (2) zur Extraktion von Daten aus CAD-Plänen (3), wobei die Daten insbesondere eine Zuordnung von CAD-Zeichnungselementen zu Betriebsmitteln darstellende Qualifizierungsdaten sind,
• zweiten Mitteln (4) zur Ablage der extrahierten Daten in einer Standardsprache, insbesondere in XML und
• einer Template-Datei (5) zur Steuerung eines Generiervorgangs mindestens einer Bedienoberfläche (6), insbesondere zur Zuordnung von Betriebsmitteln zu für die Darstellung der Betriebsmittel auf der Bedienoberfläche (6) verwendbaren Bildelementen,
wobei eine Generierung und/oder Modifikation einer Bedienoberfläche anhand der Daten, insbesondere der Qualifizierungsdaten und einer in der Template-Datei enthaltenen, insbesondere in XML vorliegenden Generiervorschrift (55), vorgesehen ist.

2. System nach Anspruch 1, bei dem ein HMI-Generator zur Generierung und/oder Modifikation der Bedienoberfläche vorgesehen ist.

3. System nach Anspruch 1 oder 2, bei dem die ersten Mittel (2) zur Extraktion von in den CAD-Plänen (3) enthaltenen Informationen, insbesondere Komponenten- und/oder Struktur-und/oder Geometrieinformationen vorgesehen sind, wobei die Informationen als Daten, insbesondere DXF Dateien, in einem Speicher gespeichert sind.

4. System nach einem der vorhergehenden Ansprüche, bei dem die ersten Mittel zur Ableitung von Prozessvariablen, insbesondere zur Darstellung der Prozessanbindung, aus den Qualifizierungsdaten vorgesehen sind.

5. System nach einem der vorhergehenden Ansprüche, bei dem Gruppen von Betriebsmitteln gemeinsam, insbesondere als HMI-Area (8), darstellbar sind.

6. System nach Anspruch 5, bei dem ein auf Basis von im CAD-Plan (3) enthaltenen Geometriedaten ein Hintergrundbild einer Gruppe von Betriebsmitteln zuordenbar ist.

7. System nach einem der vorhergehenden Ansprüche, bei dem die durch die zweiten Mittel extrahierten Qualifizierungsdaten zur zusätzlichen Qualifikation durch einen Projekteur vorgesehen sind.

8. System nach einem der vorhergehenden Ansprüche, bei dem die Template-Datei zur Modifikation durch einen Projekteur vorgesehen ist.

9. System nach einem der vorhergehenden Ansprüche, bei dem ein Generierprotokoll zur Protokollierung der Generierung und/oder Modifikation der Bedienoberfläche, insbesondere in XML, vorgesehen ist.

10. Verfahren zur Generierung und/oder Modifikation von Bedienoberflächen, insbesondere von B&B Systemen in der Automatisierungstechnik, bei dem
• Daten, insbesondere Qualifizierungsdaten extrahiert werden, wobei die Qualifizierungsdaten insbesondere eine Zuordnung von CAD-Zeichnungselementen zu Betriebsmitteln darstellen,
• die extrahierten Daten, insbesondere die Qualifizierungsdaten, in einer Standardsprache, insbesondere in XML, abgelegt werden und
• ein Generiervorgang mindestens einer Bedienoberfläche durch eine Template-Datei gesteuert wird, wobei insbesondere eine Zuordnung von Betriebsmitteln zu für die Darstellung der Betriebsmittel auf der Bedienoberfläche verwendbaren Bildelementen erfolgt,
wobei eine Generierung und/oder Modifikation einer Bedienoberfläche anhand der Daten, insbesondere der Qualifizierungsdaten und einer in der Template-Datei enthaltenen, insbesondere in XML vorliegenden Generiervorschrift, erfolgt.

11. Verfahren nach Anspruch 10, bei dem die Generierung und/oder Modifikation der Bedienoberfläche durch einen HMI-Generator erfolgt.

12. Verfahren nach Anspruch 10 oder 11, bei dem in CAD-Plänen enthaltenen Informationen, insbesondere Komponenten- und/oder Struktur- und/oder Geometrieinformationen extrahiert werden,
wobei die Informationen als Daten, insbesondere DXF Dateien, in einem Speicher gespeichert sind,

13. Verfahren nach einem der Ansprüche 10 bis 12, bei dem eine Ableitung von Prozessvariablen, insbesondere zur Darstellung der Prozessanbindung, aus den Qualifizierungsdaten erfolgt.

14. Verfahren nach einem der Ansprüche 10 bis 13, bei dem Gruppen von Betriebsmitteln gemeinsam, insbesondere als HMI-Area, dargestellt werden.

15. Verfahren nach Anspruch 14, bei dem ein auf Basis von im CAD-Plan enthaltenen Geometriedaten ein Hintergrundbild einer Gruppe von Betriebsmitteln zugeordnet wird.

16. Verfahren nach einem der Ansprüche 10 bis 15, bei dem die extrahierten Qualifizierungsdaten zusätzlich durch einen Projekteur qualifiziert werden.

17. Verfahren nach einem der Ansprüche 10 bis 16, bei dem die Template-Datei durch einen Projekteur modifiziert wird.

18. Verfahren nach einem der Ansprüche 10 bis 17, bei dem die Generierung und/oder Modifikation der Bedienoberfläche, insbesondere in XML, protokolliert wird.
